# EUROPEAN PATENT APPLICATION

(11) **EP 3 944 313 A1**
(43) Date of publication of application: **26.01.2022**
(21) Application number: 20186732.2
(22) Date of filing: 20.07.2020
(51) Int. Cl.: H01L 25/075, H01L 33/50, H01L 33/54, F21S 43/14

(54) **LIGHT SOURCE, SIGNAL LAMP COMPRISING THE LIGHT SOURCE AND METHOD FOR MANUFACTURING THE LIGHT SOURCE**

(71) Applicant: Lumileds LLC, San Jose, CA 95131 (US)
(72) Inventor: The designation of the inventor has not yet been filed
(74) Representative: ter Heegde, Paul Gerard Michel

(57) **Abstract**

A light source, in particular a multi-color light source, comprising at least one first light emitting diode, LED, die covered by a first filling containing a first phosphor such that a first die color is converted to a first illuminous color; at least one second LED die covered by a second filling containing a second phosphor such that a second die color is converted to a second illuminous color, wherein the first illuminous color is not converted by the second phosphor. A signal lamp, in particular for automobiles requiring the provision of a plurality of lighting function simultaneously, comprising the light source. A light source workpiece, in particular a chip-on-board, COB, light source workpiece for manufacturing a plurality of the light sources, comprising a substrate and a plurality of light sources, wherein each light source comprises at least one first LED die and at least one second LED die. A method for manufacturing a plurality of the light sources using the light source workpiece, comprising depositing the substrate, mounting a plurality of LED dies, configuring electrical connections within the plurality of LED dies, depositing a respective filling over the plurality of LED dies, wherein between neighboring light sources a plurality of dams is deposited.

## Description

### FIELD OF THE INVENTION

The present invention relates to a light source, in particular a multi-color light source, and a signal lamp comprising the light source, in particular for automobiles where a plurality of lighting functions is to be provided at the same time.

### BACKGROUND OF THE INVENTION

A Daytime Running Lamp (DRL) is a mandatory lighting device which is automatically switched on when a vehicle is driving on the road. According to, for instance, EU regulations, DRL lights must be kept on during driving, which then necessitates the development of multifunction lighting modules equipped on the vehicles. Common combinations of lightning functions include a DRL/Turn combination, a Backup/Turn combination and etc. To realize such combinations, multi-color light sources are employed. Take a DRL/Turn module as an example, a two-color light source is required.

For the production of the above mentioned multi-color light sources, it has been proven to be most cost effective to use a Chip-on-Board (CoB) technology. The CoB technology refers to that, instead of packaging the individual semiconductor devices comprised in the respective light emitting diode (LED) separately, multiple LED chips (or dies) are directly bonded to a substrate, for instance, a printed circuit board (PCB) such that a single module containing a number of LED chips is formed thus reducing the space, the weight as well as the costs during the manufacturing process. More specifically, for the production of a two-color light source, it is common practice that multiple strings of LED dies are mounted on a substrate, following which one part of the LED die strings is covered by one filling containing a certain kind of color converting phosphor while another part of the LED die strings is covered by another filling containing another kind of color converting phosphor. The two parts of LED die strings could employ blue LED dies such that, after being converted by their respective fillings, the respective illuminous colors perceived by viewers regarding the two parts of LED die strings are different from each other, such as white and red for example. However, the closeness of the two parts of LED die strings increases the possibility of mixture of lights such that the viewers perceive mixed colors.

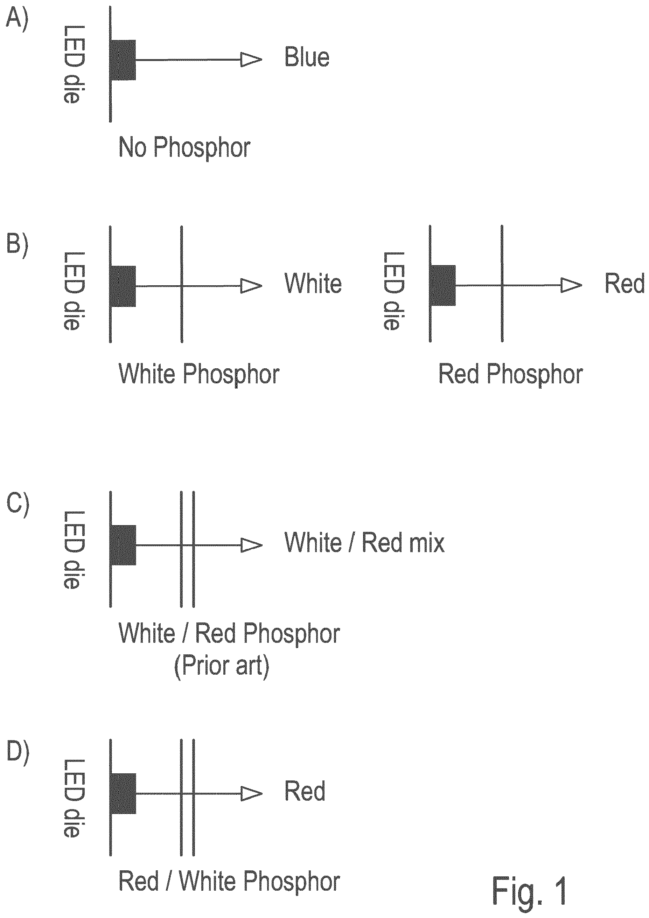

With reference to Fig. 1, the techniques applied for the production of a two-color light source used in the art is illustrated. As shown in Fig. 1B, a white phosphor converts a blue LED die color to white whereas a red phosphor converts the blue die color to red. As is mentioned above, in order to render two distinct colors, two different phosphors are needed. However, a certain degree of color mixture takes place if the blue color emitted by the LED die firstly goes through a white phosphor and then goes through a red phosphor. For instance, as is shown in Fig. 1C, what is rendered is a mix of white and red (thus pink), and not two distinct colors. This is due to that, for instance, the blue portion comprised in the white color is converted by the red phosphor. Thus, for distinct colors, the phosphors need to be placed next to each other. Typically, this is done by placing a dam between the two phosphors.

There is thus a need to efficiently avoid mixture of colors in the multi-color light source products. Additionally, it is also demanded that the multi-color light source products are more compact and less costly, which are produced by manufacturing processes that are more efficient.

### SUMMARY OF THE INVENTION

It is an object of the present invention to provide a light source, in particular a multi-color light source, that is more compact in structure and less complex in the manufacturing process. It is further an object of the present invention to provide above-mentioned light sources that are in the meantime capable of effective color separation between at least two different colors. These objects are achieved by a lighting device in accordance with claim 1.

It is also an object of the present invention to provide a signal lamp which comprises the above-mentioned light source, in particular for automobiles which require the provision of a plurality of lighting functions. This object is achieved in accordance with claim 11.

It is a further object of the present invention to provide a light source workpiece as well as a method for manufacturing the light source workpiece, which are less complex and more efficient. This object is achieved in accordance with claim 17 as well as claim 21.

Following the above-mentioned principle and according to the present invention, there is provided a light source and more specifically a multi-color light source. The light source comprises a first light emitting diode, LED, die emitting a first die color; and a first filling arranged over the first LED die, the first filling comprising a first phosphor such that the first die color is converted to a first illuminous color. The light source further comprises a second LED die emitting a second die color; and a second filling arranged over the second LED die, the second filling comprising a second phosphor such that the second die color is converted to a second illuminous color, wherein the first illuminous color is different from the second illuminous color, and the first illuminous color is not converted by the second phosphor, wherein the second illuminous color passes over the first filling such that the first illuminous color and the second illuminous color are separated, and more particularly are spatially separated, from each other. Additionally, the light source can comprise more than one first LED dies and/or more than one second LED dies. Therein, the first die color and the second die color refer to the respective colors that are directly emitted by the first LED die and the second LED die. The first die color and/or the second die color can be any one of red, green, blue as well as cyan. The second die color could be (nearly) equal to the first die color. The first LED die and the second LED die each are covered by a respective filling such that the first die color and the second die color are then each converted to a respective illuminous color by passing through a respective phosphor. It is thus achieved according to the present invention through the arrangement of the first filling and the second filling that the first illuminous color does not get converted by the second phosphor. By way of this, an undesired color mixture of the first illuminous color and the second illuminous color is reduced or even eliminated. Further, the arrangement of the present invention further prevents the light of the second phosphor from being converted by the first phosphor such that the first illuminous color and the second illuminous color are separate. In particular, by "separated" it is meant that the observing eyes of viewers can perceive a distinct multi-color light pattern where the colors are distinguished as being separated, and more particularly spatially separated, from each other, i.e. at different locations different, distinct colors are visible. Since the second illuminous color passes over the first filling, the second illuminous color is not transmitted through the first filling such that no, or almost no, color conversion can take place in the first filling. In particular, the eyes that are observing from the outside of, or mostly from above of, the light source can discern a two-color light pattern. It could be that a portion of the second illuminous color transmitted from, for instance, the lower side of the second LED die, might transmit through the first filling, the amount of such a side transmission compared with that of non-side transmission is ignorable such that the eyes' distinguishing two separate and distinct colors will not be interfered with. In other words, since the second illuminous color pre-dominantly passes over the first filling, the separation of the first illuminous color and the second illuminous color is improved.

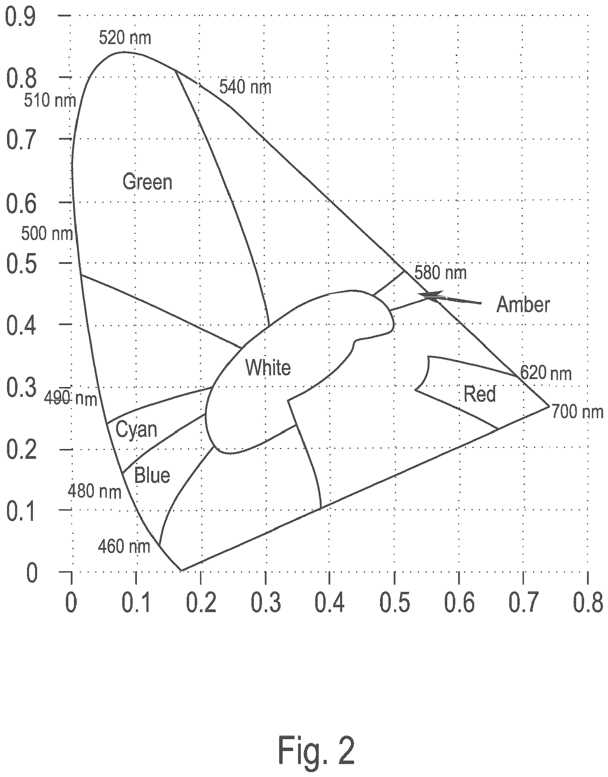

Preferably, an illumination energy of the first illuminous color is lower than an absorption energy of the second phosphor such that the separation between the first illuminous color and the second illuminous color is enhanced. The wavelength λ (which is indicated at the edge of the color diagram in Fig. 2) is related to energy E via E = (hc)/ λ, where h is Planck's constant and c is the speed of light. As illustrated in Fig. 2, a certain level of energy consumption is needed for the color conversion from one color point to another. Thus, a lower energy of the first illuminous color than the absorption energy of the second filling ensures that, even if the first illuminous color passes through the second filling, the first illuminous color does not get converted by the second phosphor contained in the second filling. In other words, no color conversion takes place anymore in the second phosphor when the first illuminous color passes therethrough. By way of this, the separation between the first illuminous color and the second illuminous color is even further enhanced.

Preferably, the first die color is blue, and/or the second die color is blue. Blue gives enough energy to be shifted to almost any other color point. Of course, the first die color and the second die color can be either the same or different from one another depending on the requirement of the lighting relative to the illuminous color emitted by the light source.

Preferably, the first illuminous color is red or amber, and the second illuminous color is white. Therein, white is a mix of at least two wavelengths, e.g. blue (~450nm) and yellow (~560nm).

Preferably, the first illuminous color is white or red or amber and the second illuminous color is cyan.

Preferably, the first filling is configured in a waterdrop shape and more specifically the first filling is configured with a convex surface. With such a waterdrop shaped structure of the first filling, it is further ensured that the second illuminous light pre-dominantly passes over the convex surface of the first filling, which thus avoids the second illuminous color passing through the first filling and thus getting converted to an unwanted color. By way of this, the color conversion of the second illuminous color in the first filling is minimized. Of course, the specific radius of the waterdrop shape, or the curvature of the convex surface, of the first filling is adapted to the distance between the first LED die and the second LED die, the required thickness of the material for color conversion. In particular, adapting is made by adapting the surface tension of the applied fillings to control the shape of the convex surface. The present invention thus is not limited thereto and can be adapted according to different manufacturing and lighting requirements.

Preferably, a third LED die is comprised in the light source and emits a third die color. A third filling is arranged over the third LED die such that a third illuminous color is provided. Therein, the third filling is preferably transparent such that the third illuminous color is the same as the third die color. In this case, the third filling contains no phosphor such that no color conversion takes place when the third die color passes through the third filling. It is thus also ensured that the first illuminous color and the second illuminous color do not get converted by the third filling. Therefore, the multi-color separation provided by the present invention comprises not only the separation of two colors but also the possibility of avoiding mixture between three different colors. Alternatively, the third filling comprises a third phosphor to convert the third die color to a third illuminous color different from the first illuminous color and/or the second illuminous color.

Preferably, the third illuminous color passes over the first filling and/or the second filling such that the third illuminous color is separated from the first illuminous color and/or the second illuminous color. Similar to what is mentioned above regarding the second illuminous color passing over the first filling, in the present case, the third illuminous color also passes over the first filling and/or the second filling without passing therethrough such that the third illuminous color is at least spatially separated therefrom. Preferably, any illuminous color which passes through another filling (phosphor) has a lower energy than the absorption energy of this other phosphor, such that the illuminous color does not get converted by this other phosphor. Alternatively, any light emitted by a phosphor with a higher energy than the absorption energy of any other phosphor(s) should be arranged such that it does not pass through the other phosphor(s) preferably by separating the fillings by one or more dams.

Preferably, the first illuminous color is red or amber, the second illuminous color is white and the third illuminous color is cyan. Further, in the present case, the third die color is either the same or different from the first die color and/or the second die color. For instance, the first die color and the second die color can be blue while the third die color can be blue or cyan. Thus, the third illuminous color being cyan can be formed either directly by the die color or by the die color being converted by a phosphor in the third filling.

Preferably, the first filling, the second filling and the third filling are made of silicon.

Preferably, the distance between the first LED die and the second LED die is less than 50mm, preferably less than 20mm and more preferably less than 10mm.

According to the present invention, there is furthermore provided a signal lamp, in particular for automobiles where a plurality of lightning functions is to be provided at the same time, wherein the signal lamp comprises a light source as mentioned above.

Preferably, the plurality of lightning functions comprises DRL and Turn light.

Alternatively, the plurality of lightning functions comprises Position Lamp and Turn light.

Alternatively, the plurality of lightning functions comprises DRL, Turn Light and Position Lamp.

Preferably, the plurality of lighting functions is provided simultaneously in a reflector. By way of this, a multi-color pattern emitted by the light source is reflected such that drivers and pedestrians can better recognize the vehicle even in low light intensity.

Preferably, the plurality of lighting functions is provided simultaneously in a light guide. By applying the present invention to a light guide, flexible and specified lighting with multiple colors is possible.

Therefore, in accordance with the signal lamp provided by the present invention, it is an additional advantage of the present invention that the light source as mentioned above can also be integrated with different modules of a automobile lighting system such that various safety regulations can be met.

According to the present invention, there is furthermore provided a light source workpiece, in particular a Chip-on-Board (CoB) light source workpiece for manufacturing a plurality of light sources as mentioned above.

The light source piece comprises a substrate; a plurality of first LED dies arranged on the substrate and covered by a first filling; and a plurality of second LED dies arranged on the substrate and covered by a second filling, wherein each light source comprises at least one first LED die and at least one second LED die. Thus, by making use of CoB technology, it is also enabled to configure a plurality of light sources on a substrate which contains multiple LED dies. The deposit of the first filling and the second filling can thus be applied for the batch of light sources, which greatly increases the manufacturing efficiency and reduces the costs. In other words, it is not necessary anymore to separately arrange the fillings over single LEDs nor to package the LEDs independently. It is thus advantageous of the present invention that light sources, taking up less space and requiring lower costs and in the meantime exhibiting effective color separation of at least two colors, can be highly efficiently produced by employing the CoB technology.

Preferably, a plurality of third LED dies is comprised in the light source workpiece. The plurality of third LED dies is arranged on the substrate and is covered by a third filling. In this case, each light source further comprises at least one third LED die such that a multi-color lighting without interference between the three colors is provided by the present invention.

Preferably, a plurality of dams is arranged on the substrate between neighboring light sources such that a multi-color light emitted by each light source does not interfere with its neighboring light sources.

Preferably, the first plurality of LED dies and/or the second plurality of LED dies and/or the third plurality of LED dies are arranged in parallel. The parallel configuration of the LED dies reduces the manufacturing complexity and thus increases the efficiency.

According to the present invention, there is furthermore provided a method for manufacturing a light source workpiece as mentioned above. The method comprises step a. depositing a substrate; step b. mounting a plurality of LED dies on the substrate, the plurality of LED dies being divided into at least a plurality of first LED dies and a plurality of second LED dies; step c. preferably configuring electrical connections for the plurality of LED dies; step d1. depositing a first filling over the plurality of first LED dies; step d2. depositing a second filling over the plurality of second LED dies. The electrical connections can also be carried out simultaneously to depositing fillings; or can be carried out after the fillings are deposited. Preferably, the plurality of LED dies can be mounted on a substrate in such a manner that the LED dies are arranged in parallel columns and rows. By way of this, the deposit of the first filling and the second filling can be easily done without complexity.

In addition, the substrate can be a PCB, such as CEM3, FR4, FR5, which is with or without inlay (e.g. Cu, AIN) or vias. The substrate can also be IMS (e.g. Al, Cu) with or without pedestal. The substrate can also be ceramic (e.g. AIN, A12O3). The LED dies can be mounted on the substrate by way of glue or by soldering. Moreover, the electrical connections can be wire bonds or printed Cu lines (PCB, IMS). Thus, the electrical connections within the LED dies and between the LED dies and the substrate together with the bonding of the LED dies to the substrate are of a low complexity which results in a high efficiency of the manufacturing process.

Preferably, a plurality of third LED dies is comprised on the substrate, wherein the method further comprises step d3. depositing third filling over the plurality of third LED dies. It is evident that the manufacturing method provided by the present invention is easily extendible to a multi-color which comprises more than two different colors without increasing the manufacturing complexity.

Preferably, of at least one of method steps d1, d2 and/or d3, a curing is applied to the respective filling(s). Curing materials and related techniques are known to the person skilled in the art and thus the present invention is not limited to any specific material or technique applied. Typically, curing is done using an oven or by UV radiation.

Preferably, the plurality of LED dies is arranged in such a manner that a plurality of light sources as previously discussed is formed on the light source workpiece. Therein each light source comprises at least one first LED dies and at least one second LED die such that at least a two-color pattern with an effective separation of the multiple colors is achieved. Preferably, each light source also comprises at least one third LED die such that a three-color lighting is achieved. Preferably, the manufacturing method further comprises step d4. depositing a plurality of dams between neighbouring light sources such that multi-color lighting from each light source does not interfere with his neighbouring light sources. It is thus evident that the color interference between light sources is easily avoided by depositing a plurality of dams therebetween. Thus, a highly efficient manufacturing process for the production of a plurality of versatile multi-color light sources is provided by the present invention.

Preferably, the first plurality of LED dies and/or second plurality LED dies and/or the third plurality of LED dies are arranged in parallel. As it is mentioned above, the parallel configuration of the plurality of the LED dies further reduces the manufacturing complexity and costs induced.

In summary, the present invention provides a multi-color light source which is of a simple configuration and takes up less space; the light source can be integrated to a signal lamp on automobiles providing a plurality of lightning functions at the same time such that various demands of the client and in the meantime regulations of the law can be met. The present invention further provides a method for manufacturing in a fast and simple manner a plurality of such light sources by way of using a light source workpiece, which manufacturing method is of reduced complexity, high efficiency and low costs. Furthermore, according to the present invention the multi-color separation of the lightning pattern emitted by the light source is further enhanced in addition to those aforementioned advantages.

### BRIEF DESCRIPTION OF THE DRAWINGS

Non-limiting and non-exhaustive embodiments of the present invention as described above are referenced to the following drawings, wherein same or similar elements are indicated by identical reference signs.
- Fig. 1: a schematic drawing comparing the color conversion principle used in the prior art with that in accordance with the present invention,
- Fig. 2: a diagram of approximate color regions on CIE color space,
- Fig. 3: a front view of an embodiment in accordance with the present invention compared with another front view where the principle in accordance with the present invention is not used,
- Fig. 4A-4C: three front and top views of three respective embodiments in accordance with the present invention,
- Fig. 4D: a top view of an embodiment in accordance with the present invention, and
- Fig. 5: a schematic drawing of a light source workpiece in accordance with the present invention.

### DETAILED DESCRIPTION OF THE DRAWINGS

In the following description, for purposes of explanation rather than limitation, specific details are set forth such as the particular architecture, interfaces, techniques, etc., in order to provide a thorough understanding of the concepts of the present invention. However, it will be apparent to those skilled in the art that the present invention may be practiced in other embodiments, which depart from these specific details. In like manner, the text of this description is directed to the example embodiments as illustrated in the Figures and is not intended to limit the claimed invention beyond the limits expressly included in the claims. For purposes of simplicity and clarity, detailed descriptions of well-known devices, circuits, and methods are omitted so as not to obscure the description of the present invention with unnecessary details. The following description should not be understood to limit the assignment of any specific feature to a specific embodiment. Thus, the features of the embodiments mentioned hereinafter can be freely combined with each other.

Referring to Fig. 1C, the mix of colors existent in the art happens because the color point of red in the color space is further away from the color point of blue compared with the color point of white. In this regard, reference is made to Fig. 2 which shows a color space of visible light spectrum wherein the color points of red, amber, green, cyan, blue and white are illustrated.

In Fig. 2, it is shown that the distance between the color point of blue and the color point of red is greater than that between blue and white. Thus, as illustrated in Fig. 1D, if the blue color encounters firstly the red phosphor and then the white phosphor, the illuminous light that comes out from the white phosphor is still in the color of red. The reason for that is that the converted red color does not undergo any conversion anymore when it passes through the white phosphor.

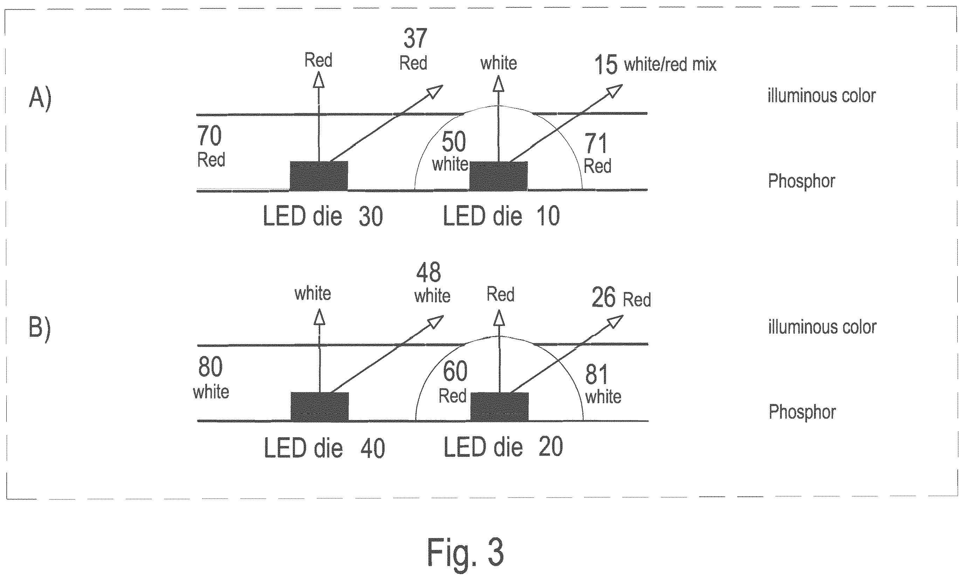

Accordingly, Fig. 3 illustrates two cases wherein in the case of Fig. 3A an undesired mix of two colors is still present whereas in the case of Fig. 3B the two illuminous colors are separated. Referring to Fig. 3A, a LED die 10 is covered by a filling 50 containing a white phosphor and another LED die 30 is covered by another filling 70 containing a red phosphor. Similar to the filling 70, there is also a filling 71 containing a red phosphor and covering another LED die which is not shown in Fig. 3A. As is illustrated in Fig. 3A, a white illuminous color 15 coming out from the white phosphor still gets converted by the red phosphor comprised in the filling 71, which thus results in an undesired mix of white and red illuminous colors. In the present two cases, blue colored LED dies are used as an example, which however does not limit the present invention in this regard. As mentioned above, white is a mix of at least two wavelengths, e.g. blue (~450nm) and yellow (~560nm). Therefore, according to the color regions shown in Fig. 2, the undesired mix takes place because of reabsorption of white in the red phosphor, as white contains light with a higher energy (shorter wavelength). Hence, the white illuminous color 15, when encountering the red phosphor, is still converted to a red illuminous color.

By contrast, Fig. 3B illustrates that according the present invention such an undesired mix can be avoided. Therein, a first LED die 20 is covered by a first filling 60 containing a first phosphor which in the present case is a red phosphor; and a second LED die 40 is covered by a second filling 80, 81 containing a second phosphor which in the present case is a white phosphor. In addition, the second filling 80 is arranged in Fig. 3B to the left of the first filling 60 whereas another portion of the second filling, namely 81, is arranged to the right of the first filling 60. It is of course also applicable if the filling 81 covers another LED die which is, however, not shown in Fig. 3B. Since the first die color, in the present case blue, is already converted by the first phosphor to a first illuminous color 26, which is red in the present case, the further encounter of the first illuminous color 26 with the second filling 81 does not induce any color conversion anymore. Thus, according to the present invention, the arrangement of the first LED die together with the first filling as well as the second LED die together with the second filling ensures that the first illuminous color does not get converted even if the first illuminous color encounters the second phosphor.

Although it is mentioned above that both the first die color and the second die color is blue, it is evident that the skilled person understands that the colors of the LED dies can be the same or different and further can be other colors such as, but not limited to, red, green and cyan. Thus, taking the case where the first die color and the second die color are blue as an example, the first illuminous color can also be amber when the second illuminous color is white. Further, the first illuminous color can be anyone of white, red and amber whereas the second illuminous color is cyan. The skilled person understands that he can select within his expertise different combinations of colors according to the color regions illustrated in Fig. 2.

Still referring to Fig. 3B, it is shown that the first filling 60 is waterdrop shaped and further is with a convex surface. This is advantageous in that the second illuminous color 48, along its three-dimensional propagation path, may still encounter the first filling 60 such that portions of the second illuminous color 48 further get converted by the first phosphor to the first illuminous color red. Therefore, by configuring a convex surface of the first filling 60, the rays of the second illuminous color 48, which would otherwise get converted, can pre-dominantly pass over the convex surface of the first filling 60 and thus does not pass through the first filling 60. As mentioned above, the portion of the second illuminous color 48 transmitting from the right side of the second LED die 40 toward the left lower part of the surface of the first filling 60 (this portion of the second illuminous color 48 not shown in Fig. 3B), which although might transmit through the first filling 60, is negligible. What the observing eyes perceive is a distinct color separation. It is thus evident that the curvature of the convex surface of the first filling 60 can be selected by the person skilled in the art according as well to the distance between the first LED die 20 and the second LED die 40 and the diameter of the sphere formed by the first filling 60, which also is related to the characteristics of the material applied in the first filling 60. The present invention does not intend to limit the skilled person in his choices of the material of the fillings as well as the specific parameters concerning the LED dies during his specific manufacturing process.

In summary, as is illustrated in Fig. 3B and according to the present invention, the configuration of the first LED die, the second LED die, the first filling as well as the second filling ensures that the first illuminous color does not get converted by the second phosphor contained in the second filling; further to that, the arrangement that the first illuminous color having a lower energy than the absorption energy of the second phosphor ensures that even if the first illuminous color has to physically go through the second phosphor, no color conversion takes place anymore; and moreover, the convex surface of the water-drop shaped first filling ensures that rays of second illuminous color, for instance, by forming tangent lines upon the convex surface of the first filling, pre-dominantly pass over the convex surface thereof without passing through the first filling so as to avoid getting converted to the second illuminous color.

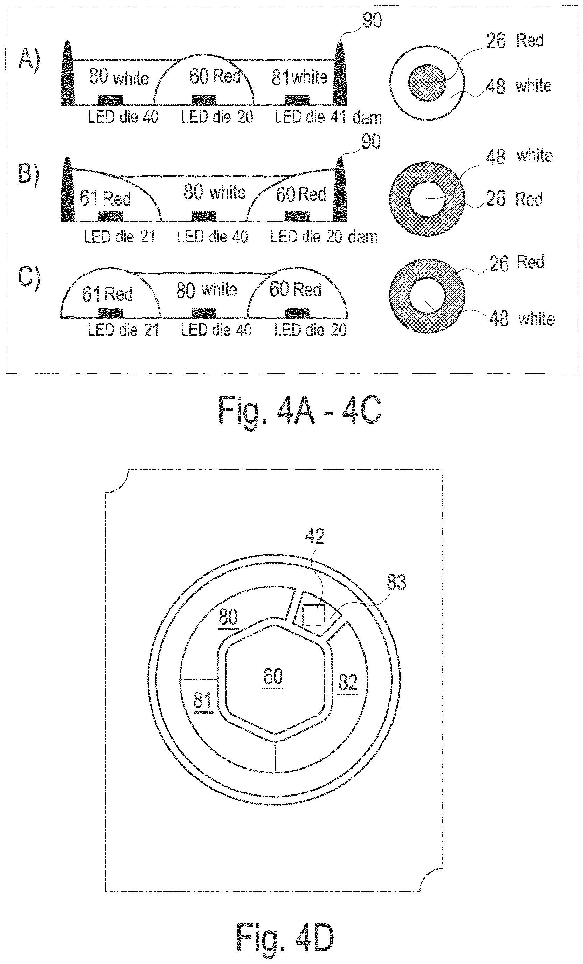

Accordingly, Fig. 4 illustrates several embodiments in accordance with the present invention.

Fig. 4A refers to a so-called "sunny side up" configuration of an embodiment according to the present invention. Therein, there is a first LED die 20 being covered by a first filling 60 containing a red phosphor; further there exist two second LED dies 40, 41 which are respectively covered by two second fillings 80, 81 both containing a white phosphor. Due to a circular radiation pattern, the top view illustrated in Fig. 4A is presented in the form of a sunny side up egg wherein the first illuminous color 26 being red is a full circle in the center whereas the second illuminous color 48 being white exists at an outer region surrounding the first illuminous color 26. Additionally, the radius of the region encompassing the perceived first illuminous color 26 could be different from the radius of the second filing 60, as a portion of side transmitted second illuminous color 48 might transmit through the first filling 60 and thus get converted. In particular, the radius of the first illuminous color 26 region compared with the radius of the "sunny side up" region perceived by the viewers depends on the specific parameters of, for instance, the convex surface of the first filling 60.

Fig. 4B illustrates a similar example to Fig. 4A. In this case, there is provided two first LED dies 20, 21 which are positioned at respectively the left and the right side to a second LED die 40. The first LED dies 20, 21 as well as the second LED die 40 are covered by their respective fillings, namely two first fillings 60, 61 and a second filling 80. The first fillings 60, 61 each comprise a red phosphor whereas the second filling 80 comprises a white phosphor. What is formed in the respective top view of this embodiment is that the second illuminous color 48 is now presented in a center of the so-called "inverted sunny side up" configuration whereas the first illuminous color 26 exists in an outer region. Therefore, according to Figs. 4A and 4B, the present invention provides various embodiments wherein different color patterns, containing two separate colors, are provided for fulfilling versatile requirements to be met on the automobiles.

It is also noted that in Fig. 4A as well as in Fig. 4B, two dams 90 are provided respectively at both ends of the two embodiments. These dams 90 are configured for the purpose of further avoiding interference between adjacent light sources. In the case of Fig. 4A and 4B, there is illustrated merely one light source containing in total three LED dies. However, as will be explained later in the description, the manufacturing process takes place on a substrate which encompasses a plurality of light sources, which thus necessitates the usage of dams configured between neighboring light sources to avoid interferences.

Nevertheless, referring to Fig. 4C which shows another embodiment in accordance with the present invention, the usage of dams 90 can also be avoided. Fig. 4C illustrates a similar embodiment to Fig. 4B, wherein in Fig. 4C no dams 90 are used since the two first LED dies 20, 21 are in the shape of a full hemisphere (waterdrop). More specifically, Fig. 4C illustrates complete hemispheres for the first fillings 60, 61, whereas in Fig. 4B there exist only a half of the hemisphere of the first fillings 60, 61. Thus, in the case of Fig. 4C, the convex surface of the first fillings 60, 61 automatically reduces and even excludes interferences between neighboring light sources, since any rays of light that propagate toward the surface of the first fillings 60, 61 from neighboring light sources form tangent lines upon the convex surfaces and thus merely pass over the surfaces without passing through the first fillings 60, 61. Therefore, the present invention, apart from providing various multi-color lightings with reduced mix of different illuminous colors, also provides flexible ways of specific configurations depending on, for instance, materials used for the fillings and specific parameters induced during specific manufacturing processed fulfilling the requirements of the expected lighting on the automobiles.

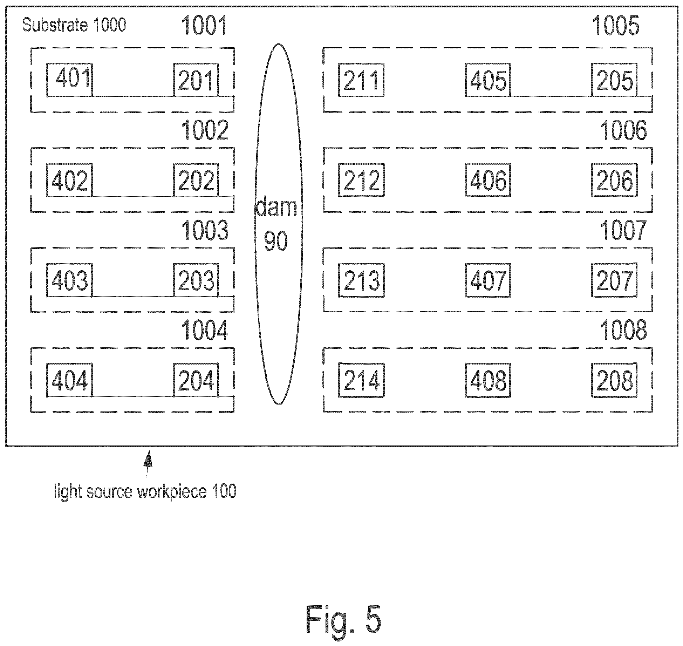

Fig. 4D shows another embodiment in accordance with the present invention, wherein a third LED die 42 covered by a third filling 83 is included in addition to a first LED die (not shown) and a second LED die (not shown) compared with Figs. 4A-4C. In the top view illustrated in Fig. 4D, a first filling 60 and a plurality of second fillings 80, 81 and 82 are presented. The arrangement of the first filling 60 and the second fillings 80-82 is similar to that as mentioned above except that in Fig. 4D, instead of merely one complete second filling, a plurality of second fillings are provided each covering a respective second LED die. Of course, the colors of the respective phosphors comprised in the plurality of second fillings can either be the same or different depending on the specific multi-color pattern that is required. The separation of the second LED dies can be accomplished by using a plurality of dams. In particular, according to Fig. 4D, a third illuminous color is provided after transmission of light through the third filling 83. Similar to the second illuminous color, the third illuminous color passes over the first filling 60 such that the third illuminous color is at least physically/spatially separated from the first illuminous color. Additionally, and more preferably, the third illuminous color also passes over the third filling 80 and/or 82 for it to be further separated from the respective third fillings. Thus, a water-drop shape can be employed for the first filling 60 and/or the second fillings 80-82. Preferably, a plurality of dams can be applied between the first filling 60, the second fillings 80-82 and/or the third filling 83. Furthermore, undesired color conversion does not take place by, for instance, the first illuminous color being (or amber) with the second illuminous color(s) being white while the third illuminous color is blue or cyan. Thus, by ensuring that the energy of the first illuminous color and/or the second illuminous color(s) is lower than that of the absorption energy of the third filling 83 (comprising the third phosphor if necessary), further improvement in color separation is achieved. In addition, the third filling 83 can be transparent if using a blue third LED die 42. In the case of a cyan third die color, UV plus phosphor is employed in the third LED die 42 for achieving cyan color. It is thus achieved by the present invention to provide a three-color separation. Fig. 5 illustrates a light source workpiece 100 that is to be employed for manufacturing a plurality of light sources. Therein, a plurality of first LED dies 201 - 208 as well as 211 - 214 is arranged on a substrate 1000. Fig. 5 further illustrates that there are three strings of first LED dies, namely a string containing first LED dies 201 - 204, another string containing 205 - 208 and a third string containing 211 - 214, wherein the three strings of LED dies are arranged in parallel with each other. Further, there is a plurality of second LED dies 401 - 408 arranged on the substrate 1000, wherein a first string of second LED dies containing 401 - 404 is arranged in parallel with a second string of second LED dies containing 405 - 408. Further, it is presented in Fig. 5 that each row of LED dies is also in parallel with each other. Such a parallel configuration of the embodiment according to the present invention serves to simplify the manufacturing process such that, for instance, the depositing of filling materials as well as the dicing of separate light sources is eased with reduces complexity and costs. Therefore, as illustrated in Fig. 5, there is provided a plurality of light sources, namely 1001 - 1008. Therein, light sources 1001 - 1004 each comprises a first LED die and a second LED die whereas light sources 1005 - 1008 each comprises two of the first LED dies and one second LED die. Furthermore, in order to avoid interferences between adjacent light sources, for instance, between light source 1001 and light source 1005, a dam 90 is arranged on the substrate 1000 as well.

According to the present invention, the method of manufacturing a plurality of light sources by using the above-mentioned light source workpiece 100 can be implemented as follows. In step a, the substrate 1000 is deposited. After that, in step b, a plurality of LED dies is mounted on the substrate 1000. As mentioned above, it is preferable to mount the plurality of LED dies in such a manner that each row of LED dies is in parallel with each other and each column of LED dies is in parallel with each other as well. Thereafter, it is within the expertise of the skilled person according to specific requirements of the lighting to be manufactured that a plurality of light sources is arranged. For instance, according to Fig. 5, the LED dies 201 - 204 are evenly arranged in one column, which column is to the right of a plurality of second LED dies 401 - 404 such that four light sources 1001 - 1004 with the same configuration is formed. Another plurality of light sources 1005 - 1008 is formed in a similar manner wherein a plurality of second LED dies 405 - 408 is arranged in the middle column whereas first LED dies 205 - 208 are arranged to the right thereof and first LED dies 211 - 214 are arranged to the left thereof.

Thereafter, in step c, electrical connections within the plurality of LED dies is configured. As a next step, fillings, not shown in Fig. 5, over the respective plurality of LED dies are to be deposited on the substrate 1000. In particular, in step d1, a first filling is deposited over the plurality of first LED dies 201 - 204, 205 - 208 as well as 211 - 214. It is thus apparent that the configuration illustrated in Fig. 5 eases the depositing of the first filling. Similarly, in step d2, a second filling is deposited over the plurality of second LED dies 401 - 404 as well as 405 - 408. Additionally, in the case that there exists a plurality of third LED dies on the substrate 1000 for the formation of a three-color light, a third filling is also to be deposited in step d3 in the similar manner as described above. Further, in step e, electrical connections between all of the plurality of LED dies and the substrate 1000 are arranged, if necessary.

In practice, it is also necessary to apply a curing to the respective filling. More specifically, after steps d1, d2 and preferably d3, a respective curing is applied to the first filling, the second filling and preferably the third filling. It is also within the expertise of the skilled person to decide whether he needs to apply a curing to each of or some of or even all of the fillings.

Furthermore, after the step d1 - d3 wherein the respective filling is deposited and before the step wherein possible curing is deposited, it may be also necessary to apply a step d4 wherein a plurality of dams 90 is deposited between neighboring light sources. Take Fig. 5 as an example, and supposing that light sources 1001 - 1004 all exhibit the same sunny side up red - white light whereas the light sources 1005 - 1008 all exhibit an inverted sunny side up red - white light, it is then necessary to deposit a dam 90 between light sources 1001 - 1004 and light sources 1005 - 1008 (please refer to Fig. 4B for a similar illustration). By way of this, interferences between neighboring light sources can also be avoided in a way that is of less complexity and lower costs.

In summary, according to the method for the manufacturing of the plurality of light sources on the light source workpiece in accordance with the present invention, a plurality of multi-color light sources is easily manufactured wherein the number of method steps, the complexity as well as the costs of the manufacturing process are significantly reduced. In the meantime, each light source exhibits a clear-cut color separation between different illuminous colors and interferences between neighboring light sources during the manufacturing process are avoided without increasing manufacturing complexity and costs.

## Claims

1. A light source, in particular a multi-color light source, comprising:
a first light emitting diode, LED, die emitting a first die color;
a first filling arranged over the first LED die, the first filling comprising a first phosphor such that the first die color is converted to a first illuminous color;
a second LED die emitting a second die color; and
a second filling arranged over the second LED die, the second filling comprising a second phosphor such that the second die color is converted to a second illuminous color, wherein
the first illuminous color is different from the second illuminous color, and the first illuminous color is not converted by the second phosphor, wherein
the second illuminous color passes over the first filling such that the first illuminous color and
the second illuminous color are separated from each other.

2. The light source of claim 1, wherein an illumination energy of the first illuminous color is lower than an absorption energy of the second phosphor such that the separation between the first illuminous color and the second illuminous color is enhanced.

3. The light source of claim 1, wherein the first die color is blue, and/or the second die color is blue.

4. The light source of claim 3, wherein one of:
the first illuminous color is red or amber, and the second illuminous color is white, or
the first illuminous color is white or red or amber, and the second illuminous color is cyan.

5. The light source of claim 1, wherein the first filling is configured with a convex surface.

6. The light source of claim 1, further comprising a third LED die emitting a third die color and a third filling arranged over the third LED die such that a third illuminous color is provided.

7. The light source of claim 6, wherein the third illuminous color passes over the first filling and/or the second filling such that the third illuminous color is separated from the first illuminous color and/or the second illuminous color.

8. The light source of claim 7, wherein the first illuminous color is red or amber, the second illuminous color is white, and the third illuminous color is blue or cyan.

9. A signal lamp, in particular for automobiles where a plurality of lighting functions is to be provided at the same time, comprising a light source of claims 1 to 10, wherein the plurality of lighting function comprises one of:
Daytime Running Lamp, DRL, and Turn light, or
Position Lamp and Position Lamp, or
DRL, Turn light, and Position Lamp.

10. The signal lamp of claim 9, wherein the plurality of lighting functions is provided simultaneously in one of a reflector or a light guide.

11. A light source workpiece, in particular a Chip-on-Board, CoB, light source workpiece for manufacturing a plurality of light sources of claims 1 to 8, comprising:
a substrate;
a plurality of first LED dies arranged on the substrate and covered by a first filling; and
a plurality of second LED dies arranged on the substrate and covered by a second filling,
wherein
each light source comprises at least one first LED die and at least one second LED die.

12. The light source workpiece of claim 11, further comprising:
a plurality of dams arranged on the substrate between neighboring light sources such that a multi-color lighting emitted by each light source does not interfere with its neighboring light sources.

13. The light source workpiece of claim 11, wherein the first plurality of LED dies and/or the second plurality of LED dies and/or the third plurality of LED dies are arranged in parallel.

14. A method for manufacturing a lighting source workpiece of claim 11, comprising:
a. depositing a substrate;
b. mounting a plurality of LED dies on the substrate, the plurality of LED dies being divided into at least a plurality of first LED dies and a plurality of second LED dies;
c. preferably configuring electrical connections within the plurality of LED dies;
d1. depositing a first filling over the plurality of first LED dies; and
d2. depositing a second filling over the plurality of second LED dies.

15. The method of claim 14, further comprising:
applying a curing to the respective filling preferably after at least one of method steps d1 and/or d2 and/or d3.
